# EUROPEAN PATENT APPLICATION

(11) **EP 4 472 366 A1**
(43) Date of publication of application: **04.12.2024**
(21) Application number: 22931883.7
(22) Date of filing: 23.12.2022
(51) Int. Cl.: H05K 5/02, H05K 7/20, H05K 5/03

(54) **HOUSING ASSEMBLY OF CAPACITOR AND ELECTRIC DRIVE ASSEMBLY**

(30) Priority: 16.03.2022 CN 202210260548
(71) Applicant: Jing-Jin Electric Technologies Co., Ltd., Beijing 100015 (CN)
(72) Inventor: TIAN, Xiaokai, Beijing 100015 (CN); GALLEGOS LOPEZ, Gabriel, Beijing 100015 (CN); ZHANG, Hao, Beijing 100015 (CN)
(74) Representative: Schwarz & Partner Patentanwälte GmbH
(86) International application number: PCT/CN2022/141503
(87) International publication number: WO 2023/173877

(57) **Abstract**

A housing assembly of a capacitor and an electric drive assembly are provided. The housing assembly comprises an upper cover plate (1), an intermediate housing (2) and a lower cover plate (3). The upper cover plate (1) and/or the lower cover plate (3) are provided with a first liquid inlet (4) and a first liquid outlet (5). First cooling channels are formed respectively between the upper cover plate (1) and an upper side surface of the intermediate housing (2) and between the lower cover plate (3) and a lower side surface of the intermediate housing (2), and second cooling channels are formed respectively between an outer side surface of the upper cover plate (1) and power devices and between an outer side surface of the lower cover plate (3) and power devices. The first cooling channel comprises a partitioning protrusion (6) and a partitioning groove (7) provided in the first cooling channel and extending in a length direction of the intermediate housing (2), and the partitioning protrusion (6) extends into the partitioning groove (7) and divides the first cooling channel into a first liquid inflow cooling channel (8) and a first liquid outflow cooling channel (9). The housing assembly can realize the simultaneous cooling of the capacitor and the power devices, and can also prevent the occurrence of water leaking between the water passages, and the cooling and heat dissipation effect is better.

## Description

### Cross-reference to related applications

This application claims priority to Chinese patent application No. 202210260548.4 filed with the Chinese Patent Office on March 16, 2022 and entitled "A Housing Assembly of A Capacitor and An Electric Drive Assembly", which is incorporated by reference herein in its entirety.

### TECHNICAL FIELD

The present disclosure belongs to the technical field of motor controllers, and particularly relates to a housing assembly of a capacitor and an electric drive assembly.

### BACKGROUND

The requirements on power density of motor controllers are gradually increasing. Maximizing the capacity of power modules will effectively reduce the number of modules used, reduce the installation space, and thus improve the power density of motor controllers. The heat dissipation environment of the power module has an important influence on whether the capacity of the power module can be maximized.

A cooling water passage structure is usually provided around the power modules to cool them due to its high consistency, thereby providing a better working environment for the power modules. However, due to the tolerance problem in machining the cooling water passage structure, water leaking is likely to occur between the cooling water passages, which results in unstable pressure of the coolant in the cooling water passage, and seriously affects the heat dissipation effect of the power modules.

### SUMMARY

In view of the above problems, the present disclosure provides a housing assembly of a capacitor and an electric drive assembly to overcome or at least partially solve the above problems.

In order to achieve the above object, the present disclosure adopts the following technical solutions.

An aspect of the present disclosure provides a housing assembly of a capacitor, the housing assembly comprises an upper cover plate, an intermediate housing and a lower cover plate;
the intermediate housing is provided with an accommodating cavity for accommodating the capacitor, and an outer side surface of the upper cover plate and an outer side surface of the lower cover plate are used to install power devices;
the upper cover plate and/or the lower cover plate are provided with a first liquid inlet and a first liquid outlet, and first cooling channels are formed respectively between the upper cover plate and an upper side surface of the intermediate housing and between the lower cover plate and a lower side surface of the intermediate housing, and second cooling channels are formed respectively between an outer side surface of the upper cover plate and the power devices and between an outer side surface of the lower cover plate and the power devices;
the first cooling channel comprises a partitioning protrusion and a partitioning groove provided in the first cooling channel and extending in a length direction of the intermediate housing, and the partitioning protrusion extends into the partitioning groove and divides the first cooling channel into a first liquid inflow cooling channel and a first liquid outflow cooling channel.

Further, the partitioning grooves are located on the upper side and the lower side of the intermediate housing, and the partitioning protrusions are located on an inner side of the upper cover plate and an inner side of the lower cover plate;
or,
the partitioning protrusions are located on the upper side and the lower side of the intermediate housing, and the partitioning grooves are located on an inner side of the upper cover plate and an inner side of the lower cover plate.

Further, an inner width of the partitioning groove is consistent with a width of the partitioning protrusion.

Further, a sealing strip is provided in the partitioning groove.

Further, a guide portion is provided on the partitioning protrusion for guiding the partitioning protrusion when the partitioning protrusion is inserted into the partitioning groove.

Further, an inflow communicating channel and an outflow communicating channel are provided in the intermediate housing, which vertically penetrate the intermediate housing, the inflow communicating channel is used to communicate the first liquid inflow cooling channels on the upper side and lower side of the intermediate housing, and the outflow communicating channel is used to communicate the first liquid outflow cooling channels on the upper side and lower side of the intermediate housing.

Further, the first liquid inlet and the first liquid outlet correspond to the inflow communicating channel and the outflow communicating channel, respectively, in position.

Further, the second cooling channels comprise a plurality of coolant tanks provided on the outer side surface of the upper cover plate and the outer side surface of the lower cover plate and corresponding to the power devices in position, and the bottom of the coolant tank is provided with a second liquid inlet communicated with the first liquid inflow cooling channel and a second liquid outlet communicated with the first liquid outflow cooling channel.

Further, the first liquid inlet and the first liquid outlet are communicated through a pressure relief channel.

Another aspect of the present disclosure provides an electric drive assembly comprising a motor, a reducer and a motor controller, the motor controller uses any one of the housing assemblies as described above to accommodate a capacitor and a power device.

The advantages and beneficial effects of the present disclosure are as follows.

In the housing assembly of the present disclosure, by providing the first cooling channels on two sides of the intermediate housing, double-sided cooling of the capacitor is achieved, and the cooling efficiency is higher. Moreover, the housing assembly is also provided with the second cooling channels for cooling the power devices, which can achieve simultaneous cooling of the capacitor and the power devices, and occupies a small space and has a compact structure. In addition, by providing the partitioning protrusion and the partitioning groove between the first liquid inflow cooling channel and the first liquid outflow cooling channel, the coolant in the first liquid inflow cooling channel and the first liquid outflow cooling channel can be effectively prevented from leaking, the pressure loss of the coolant can be reduced, thereby making the flow of the coolant more stable.

### BRIEF DESCRIPTION OF DRAWINGS

By reading the detailed description of the preferred embodiments below, various other advantages and benefits will become clear to a person of ordinary skill in the art. The accompanying drawings are only used for the purpose of illustrating the preferred embodiments, and should not be considered as a limitation to the present disclosure. Moreover, throughout the drawings, the same reference numerals are used to denote the same components. In the drawings:
FIG. 1 is a perspective view of the structure of a housing assembly of a capacitor in an embodiment of the present disclosure;
FIG. 2 is a bottom view of a housing assembly of a capacitor in an embodiment of the present disclosure;
FIG. 3 is a longitudinal cross-sectional view of a housing assembly of a capacitor in an embodiment of the present disclosure; and
FIG. 4 is a top view of an intermediate housing in an embodiment of the present disclosure.

In the drawings: 1, upper cover plate; 2, intermediate housing; 3, lower cover plate; 4, first liquid inlet; 5, first liquid outlet; 6, partitioning protrusion; 7, partitioning groove; 8, first liquid inflow cooling channel; 9, first liquid outflow cooling channel; 10, sealing strip; 11, inflow communicating channel; 12, outflow communicating channel; 13, coolant tank; 14, second liquid inlet; 15, second liquid outlet; 16, pressure relief channel.

### DETAILED DESCRIPTION

In order to make the object, technical solutions, and advantages of the present disclosure clearer, the present disclosure will be described clearly and completely in conjunction with the specific embodiments and corresponding drawings. Obviously, the embodiments described are only part of rather than all of the embodiments of the present disclosure. Based on the embodiments in the present disclosure, all other embodiments obtained by those of ordinary skill in the art without paying creative work shall fall within the protection scope of the present disclosure.

The technical solutions provided by various embodiments of the present disclosure will be described in detail with reference to the accompanying drawings.

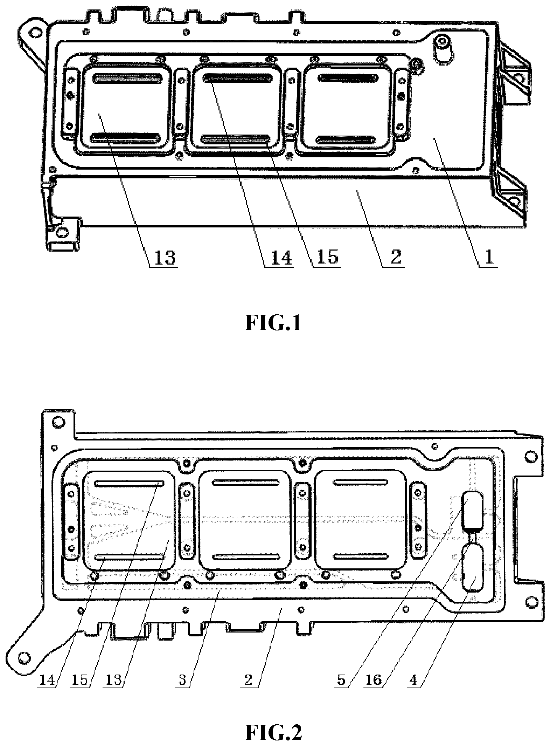

In an embodiment of the present disclosure, a housing assembly of a capacitor is provided, as shown in FIGS. 1 to 4, the housing assembly comprises an upper cover plate 1, an intermediate housing 2 and a lower cover plate 3. The upper cover plate 1 and the lower cover plate 3 are respectively fixedly connected to an upper side and a lower side of the intermediate housing 2, and more specially, the fixed connection can be achieved by stir friction welding. In addition, the intermediate housing 2 is provided with an accommodating cavity for accommodating the capacitor, and the outer side of the upper cover plate 1 and the outer side of the lower cover plate 3 are used to install power devices, and the positions of the capacitor and the power devices can be set through the housing assembly.

Specifically, the lower cover plate 3 is provided with a first liquid inlet 4 and a first liquid outlet 5. First cooling channels are formed between the upper cover plate 1 and the upper side of the intermediate housing 2, and between the lower cover plate 3 and the lower side of the intermediate housing 2, respectively. The first cooling channels are used to cool the capacitor provided in the intermediate housing 2. Second cooling channels are formed between the outer side of the upper cover plate 1 and the power devices, and between the outer side of the lower cover plate 3 and the power devices, respectively. The second cooling channels are used to cool the power devices provided on the upper cover plate 1 and the lower cover plate 3. In this way, the coolant enters from the first liquid inlet 4, then circulates in the first cooling channels and the second cooling channels, and finally flows out through the first liquid outlet 5, thereby taking away the heat generated by the capacitor and the power devices. The coolant can be water or oil, or other coolants.

The design of providing the first liquid inlet 4 and the first liquid outlet 5 on the lower cover plate 3 facilitates the coolant to flow slowly in the first cooling channels and the second cooling channels and fully perform heat exchange, and thus take away as much heat as possible. Of course, in other embodiments, the first liquid inlet and the first liquid outlet can be separately provided, for example, the first liquid inlet is provided on the lower cover plate, and the first liquid outlet is provided on the upper cover plate; or, the first liquid inlet and the first liquid outlet are both provided on the upper cover plate; or, the first liquid inlet and the first liquid outlet are both provided on the upper cover plate and the lower cover plate; these arrangements are all within the protection scope of the present disclosure.

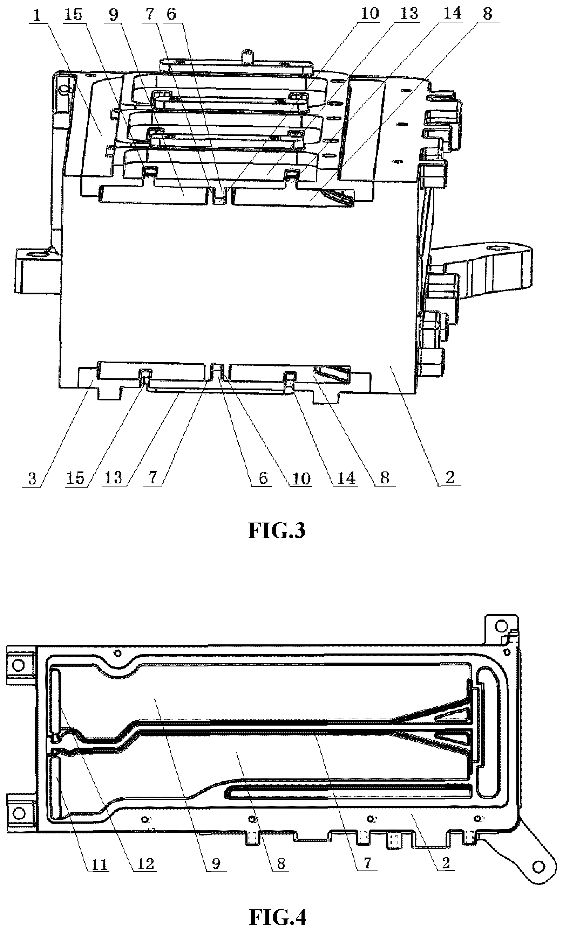

Further, as shown in FIGS. 3 and 4, the length and width of the first cooling channels are close to the length and width of the upper cover plate 1 and the lower cover plate 3, so that the coolant in the first cooling channels has a large contact area with the intermediate housing 2, thereby improving the heat dissipation efficiency.

In addition, the first cooling channel comprises a partitioning protrusion 6 and a partitioning groove 7 that are provided in a middle position of the first cooling channel and run along the length direction of the intermediate housing 2. The partitioning protrusion 6 extends into the partitioning groove 7. Through the cooperation of the partitioning protrusion 6 and the partitioning groove 7, the first cooling channel is divided into a first liquid inflow cooling channel 8 and a first liquid outflow cooling channel 9. The cooperation of the partitioning protrusion 6 and the partitioning groove 7 can effectively prevent the coolant in the first liquid inflow cooling channel 8 and the first liquid outflow cooling channel 9 from leaking, reduce the pressure loss of the coolant, and thus make the flow of the coolant in the first liquid inflow cooling channel 8 and the first liquid outflow cooling channel 9 more stable. The first liquid inflow cooling channel 8 and the first liquid outflow cooling channel 9 are communicated with the first liquid inlet 4 and the first liquid outlet 5 respectively.

In this embodiment, the housing assembly is cooled by liquid cooling. By providing the first cooling channels on both sides of the capacitor, the double-sided cooling of the capacitor is realized, and the cooling efficiency is higher. Moreover, the housing assembly is also provided with the second cooling channels for cooling the power devices. Since the power devices are laid on both sides of the capacitor, the capacitor and the power devices are cooled simultaneously, and the space occupied is small and the structure is compact, which indirectly improves the power density of the motor controller.

In an embodiment, as shown in FIG. 4, both the upper side and the lower side of the intermediate housing 2 are provided with a partitioning groove 7, and both the inner side of the upper cover plate 1 and the inner side of the lower cover plate 3 are provided with a partitioning protrusion 6. When the upper cover plate 1 and the lower cover plate 3 are assembled and fixed on the intermediate housing 2, the partitioning protrusions 6 located on the upper cover plate 1 and the lower cover plate 3 are just inserted into the partitioning grooves 7 on the upper side and the lower side of the intermediate housing 2, respectively, thereby separating the first cooling channels on the two sides of the intermediate housing 2.

The inner width of the partitioning groove 7 is consistent with the width of the partitioning protrusion 6, which can effectively prevent the coolant from leaking from the first liquid inflow cooling channel 8 into the first liquid outflow cooling channel 9 through the gap between the partitioning groove 7 and the partitioning protrusion 6. In addition, a guide portion is provided on the partitioning protrusion 6 for guiding the partitioning protrusion 6 when it is inserted into the partitioning groove 7, thereby facilitating the partitioning protrusion 6 inserting into the partitioning groove 7. For example, the guide portion is an arc structure or a chamfered structure at the top of the partitioning protrusion 6.

Further, a sealing strip 10 is further provided in the partitioning groove 7. When the partitioning protrusion 6 is inserted into the partitioning groove 7, the top of the partitioning protrusion 6 presses the sealing strip 10, so that the sealing effect between the partitioning protrusion 6 and the partitioning groove 7 is better, thereby further preventing the occurrence of liquid leaking.

Of course, in other embodiments, the partitioning protrusions may also be provided on the upper side surface and lower side surface of the intermediate housing, and the partitioning grooves are provided on the inner side surface of the upper cover plate and the inner side surface of the lower cover plate, which can also achieve the partitioning effect of the first cooling channels.

In an embodiment, as shown in FIG. 4, the intermediate housing 2 is provided with an inflow communicating channel 11 and an outflow communicating channel 12 that penetrate the intermediate housing 2 vertically. The inflow communicating channel 11 is used to communicate the two first liquid inflow cooling channels 8 on the upper and lower sides of the intermediate housing 2, and the outflow communicating channel 12 is used to communicate the two first liquid outflow cooling channels 9 on the upper and lower sides of the intermediate housing 2, so that the coolant in the first cooling channels between the upper cover plate 1 and the intermediate housing 2 and between the lower cover plate 3 and the intermediate housing 2 uses the same liquid inlet and outlet, thereby making the cooling structure simpler. The inflow communicating channel 11 and the outflow communicating channel 12 are provided at an end of the intermediate housing 2, thereby avoiding the conflict with the capacitor.

In addition, the first liquid inlet and the first liquid outlet correspond to the inflow communicating channel and the outflow communicating channel, respectively, in position so that after the coolant enters the first liquid inlet, one part directly enters the first cooling channel between the lower cover plate and the intermediate housing, and the other part enters the first cooling channel between the upper cover plate and the intermediate housing through the inflow communicating channel, so that the temperature of the coolant in the first cooling channels on the upper and lower sides of the intermediate housing is substantially the same, thereby making the heat dissipation effect of the upper and lower sides of the capacitor and the power devices on the upper and lower sides of the intermediate housing more consistent, and ensuring the uniformity of heat dissipation.

Further, the second cooling channels comprise a plurality of coolant tanks 13 provided on the outer side surface of the upper cover plate 1 and the outer side surface of the lower cover plate 3 and corresponding to the positions of power devices. The coolant tank 13 and the bottom of the power device form a cooling cavity, which can realize the cooling of the power device. The bottom of the coolant tank 13 is provided with a second liquid inlet 14 communicated with the first liquid inflow cooling channel 8 and a second liquid outlet 15 communicated with the first liquid outflow cooling channel 9. In this way, the coolant in the first liquid inflow cooling channel 8 can enter the coolant tank 13 through the second liquid inlet 14, and the coolant in the coolant tank 13 enters the first liquid outflow cooling channel 9 through the second liquid outlet 15 after heat exchange with the power device.

Preferably, three coolant tanks are provided on each of the outer sides of the upper cover plate and the lower cover plate, and a plurality of screw holes are provided on the outer periphery of the coolant tanks. The power devices are fixedly connected to the upper cover plate and the lower cover plate through screws and screw holes. The number and position of the screw holes can be adjusted as needed. In addition, a positioning hole is provided on one side of the coolant tank for positioning and installing the power device. In addition, in order to achieve the sealing between the power device and the coolant tank, a sealing ring is also provided between the power device and the coolant tank.

In an embodiment, as shown in FIG. 2, the first liquid inlet 4 and the first liquid outlet 5 are communicated through a pressure relief channel 16, so that when the coolant enters the first liquid inlet 4, part of the coolant can flow directly to the first liquid outlet 5 through the pressure relief channel 16. Since the coolant needs to be pressurized before it can enter the cooling structure on the housing assembly, and the pipeline in the cooling structure is relatively narrow, the coolant will experience a high pressure drop during the flow in the pipeline, thereby affecting the smooth flow of the coolant in the cooling structure. Therefore, when the pressure relief channel is provided between the first liquid inlet and the first liquid outlet, the pressure drop of the coolant is reduced due to the coolant entering between the first cooling channel and the second cooling channel and the coolant flows smoothly; moreover, it can be prevented that the high pressure drop damages the cooling structure in the housing assembly, thereby extending the service life of the housing assembly. For example, when the coolant enters the first liquid inlet, 80% of the coolant enters the first liquid inflow cooling channel, and 20% of the coolant flows directly to the first liquid outlet through the pressure relief channel.

The specific flow path of the coolant in the housing assembly is as follows.

After entering from the first liquid inlet, the coolant is divided into three paths. In the first path, the coolant enters the first liquid inflow cooling channel between the lower cover plate and the intermediate housing, then enters the coolant tank from the second liquid inlet, then flows into the first liquid outflow cooling channel from the second liquid outlet, and finally is discharged from the first liquid outlet. In the second path, the coolant enters the first liquid inflow cooling channel between the upper cover plate and the intermediate housing through the inflow communicating channel, then enters the coolant tank from the second liquid inlet, then flows into the first liquid outflow cooling channel from the second liquid outlet, and finally flows to the first liquid outlet through the outflow communicating channel and is discharged. In the third path, the coolant flows directly to the first liquid outlet through the pressure relief channel and is discharged.

Another embodiment of the present disclosure provides an electric drive assembly, which comprises a motor, a reducer and a motor controller. The motor controller uses the housing assembly in any of the above embodiments to install a capacitor and a power device, and realizes cooling of the capacitor and power device, so that the electric drive assembly has the advantages of high power density and good output performance.

The above merely describes particular embodiments of the present disclosure. By the teaching of the present disclosure, a person skilled in the art can make other modifications or variations based on the above embodiments. A person skilled in the art should appreciate that, the detailed description above is only for the purpose of explaining the present disclosure, and the protection scope of the present disclosure should be subject to the protection scope of the claims.

## Claims

1. A housing assembly of a capacitor, **characterized in that**: the housing assembly comprises an upper cover plate (1), an intermediate housing (2) and a lower cover plate (3);
the intermediate housing (2) is provided with an accommodating cavity for accommodating the capacitor, and an outer side surface of the upper cover plate (1) and an outer side surface of the lower cover plate (3) are used to install power devices;
the upper cover plate (1) and/or the lower cover plate (3) are provided with a first liquid inlet (4) and a first liquid outlet (5), and first cooling channels are formed respectively between the upper cover plate (1) and an upper side surface of the intermediate housing (2) and between the lower cover plate (3) and a lower side surface of the intermediate housing (2), and second cooling channels are formed respectively between the outer side surface of the upper cover plate (1) and the power devices and between the outer side surface of the lower cover plate (3) and the power devices;
the first cooling channel comprises a partitioning protrusion (6) and a partitioning groove (7) provided in the first cooling channel and extending in a length direction of the intermediate housing (2), and the partitioning protrusion (6) extends into the partitioning groove (7) and divides the first cooling channel into a first liquid inflow cooling channel (8) and a first liquid outflow cooling channel (9).

2. The housing assembly according to claim 1, **characterized in that**: the partitioning grooves (7) are located on the upper side and the lower side of the intermediate housing (2), and the partitioning protrusions (6) are located on an inner side of the upper cover plate (1) and an inner side of the lower cover plate (3);
or,
the partitioning protrusions (6) are located on the upper side and the lower side of the intermediate housing (2), and the partitioning grooves (7) are located on the inner side of the upper cover plate (1) and the inner side of the lower cover plate (3).

3. The housing assembly according to claim 2, **characterized in that**: an inner width of the partitioning groove (7) is consistent with a width of the partitioning protrusion (6).

4. The housing assembly according to claim 1, **characterized in that**: a sealing strip (10) is provided in the partitioning groove (7).

5. The housing assembly according to claim 1, **characterized in that**: a guide portion is provided on the partitioning protrusion (6) for guiding the partitioning protrusion (6) when the partitioning protrusion (6) is inserted into the partitioning groove (7).

6. The housing assembly according to claim 1, **characterized in that**: an inflow communicating channel (11) and an outflow communicating channel (12) are provided in the intermediate housing (2), which vertically penetrate the intermediate housing (2), the inflow communicating channel (11) is used to communicate the first liquid inflow cooling channels (8) on the upper side and lower side of the intermediate housing (2), and the outflow communicating channel (12) is used to communicate the first liquid outflow cooling channels (9) on the upper side and lower side of the intermediate housing (2).

7. The housing assembly according to claim 6, **characterized in that**: the first liquid inlet (4) and the first liquid outlet (5) correspond to the inflow communicating channel (11) and the outflow communicating channel (12), respectively, in position.

8. The housing assembly according to claim 1, **characterized in that**: the second cooling channels comprise a plurality of coolant tanks (13) provided on the outer side surface of the upper cover plate (1) and the outer side surface of the lower cover plate (3) and corresponding to the power devices in position, and a bottom of the coolant tank (13) is provided with a second liquid inlet (14) communicated with the first liquid inflow cooling channel (8) and a second liquid outlet (15) communicated with the first liquid outflow cooling channel (9).

9. The housing assembly according to any one of claims 1-8, **characterized in that**: the first liquid inlet (4) and the first liquid outlet (5) are communicated through a pressure relief channel (16).

10. An electric drive assembly comprising a motor, a reducer and a motor controller, **characterized in that**: the motor controller uses the housing assembly according to any one of claims 1-9 to accommodate a capacitor and a power device.
